Europäisches Patentamt

European Patent Office

Office européen des brevets

(19)

(11) Publication number: **0 350 993**

**A1**

## (12) EUROPEAN PATENT APPLICATION

(21) Application number: **89201768.2**

(22) Date of filing: **03.07.89**

(51) Int. Cl.⁴: **H03H 9/02**

(30) Priority: **12.07.88 NL 8801765**

(43) Date of publication of application:
**17.01.90 Bulletin 90/03**

(84) Designated Contracting States:
**AT BE CH DE ES FR GB GR IT LI LU NL SE**

(71) Applicant: **STICHTING VOOR DE TECHNISCHE WETENSCHAPPEN**
**Van Vollenhovenlaan 661**
**NL-3527 JP Utrecht(NL)**

(72) Inventor: **Visser, Jacobus Hendrik**
**Van Hasseltlaan 180**
**NL-2625 HK Delft(NL)**

(74) Representative: **de Bruijn, Leendert C. et al**
**Nederlandsch Octrooibureau**
**Scheveningseweg 82 P.O. Box 29720**
**NL-2502 LS 's-Gravenhage(NL)**

(54) **Surface acoustic wave device having multilayer structure with reduction in electromagnetic feedthrough.**

(57) Surface acoustic wave device having a multilayer structure comprising a semiconductor substrate (10), an insulating dielectric layer (11) thereon, a set of at least one interdigital input and output transducer (12) deposited thereon, and a piezoelectric layer (13) thereover, in which an electrical input signal is converted in the input transducer and the surface acoustic wave resulting therefrom propagates over the surface and is converted into an electrical output signal in the output transducer. A metal layer (14) which serves to reduce electromagnetic feedthrough between the input and output transducer (12) via the semiconductor substrate (10) is deposited between the semiconductor substrate (10) and the dielectric layer (11) at least at the location of the transducers (12). Said metal layer (14) may also extend over the entire interface between semiconductor substrate (10) and dielectric layer (11).

Fig-3a  Fig-3b  Fig-3c

# Surface acoustic wave device having multilayer structure with reduction in electromagnetic feedthrough.

The invention relates to a surface acoustic wave device having a multilayer structure comprising a semiconductor substrate, an insulating dielectric layer thereon, a set of at least one interdigital input and output transducer deposited thereon, and a piezoelectric layer thereover, in which an electrical input signal is converted in the input transducer and the surface acoustic wave resulting therefrom propagates over the surface and is converted into an electrical output signal in the output transducer. Such a surface acoustic wave device is known from the paper entitled "Enhancement of surface-acoustic-wave piezoelectric coupling in three-layer substrates" by A. Venema and J.J.M. Dekkers in "IEEE Trans. on Microwave Theory and Techniques, September 1975, pages 765-767.

Surface acoustic wave (SAW) devices, such as for filters, are already used on a large scale in engineering. These are provided with an interdigital input and output transducer to which the electrical signal is fed or from which it is removed respectively, and the conversion from electrical to acoustic signal and vice versa and the propagation takes place by means of piezoelectric material. An interdigital pattern of the transducers makes it possible to achieve an efficient conversion and that, in addition, said pattern can be deposited by means of a standard IC process. The required transfer characteristic of the SAW device can be achieved by giving said interdigital transducers (IDT) the correct form, viz. number of electrodes, aperture, apodization, i.e. not all the electrodes are equally long.

A piezoelectric monocrystalline material is virtually always used as substrate in commercially used SAW devices. Materials much used for this purpose are lithium niobate (LiNbO$_3$) and quartz. Lithium niobate has a high piezoelectric coupling, which makes it possible to realize filters having a large bandwidth with relatively low losses. However, the temperature stability is poor, which does not need to be a drawback in the case of filters with a large bandwidth. On certain quartz cuts, viz. ST-X-cut quartz, it is possible to realize very temperature-stable SAW devices. In this case, however, the piezoelectric coupling is low.

A serious problem in these SAW devices is the electromagnetic feedthrough, both capacitive and inductive, between the input and output transducer. The transfer characteristic becomes poorer as a result of said feedthrough, which cannot be compensated for in the design of the transducers. In some cases, the electromagnetic feedthrough is even greater than the transfer via the surface wave, and the device is unusable.

In practice there are a number of solutions for reducing this direct feedthrough, in other words, for interrupting or reducing the direct field lines between input and output transducer as much as possible. Thus, a plate having good conductivity and fitted perpendicularly between the input and output transducer would best suppress said feedthrough. In practice, however, this cannot readily be achieved. Furthermore, use is frequently made of a metal packaging which encloses the device well and/or a grounded metal layer on the bottomside of the substrate which is reasonably effective: The grounded metal screens bend the field lines towards them and they are no longer able to reach the other transducer. A multistrip coupler can also be used in practice when a configuration having high piezoelectric coupling is applied. For SAW devices based on LiNbO$_3$ or quartz, these measures for suppressing the feedthrough are adequate.

In the abovementioned paper, the use is described of a monolithically integrated unit comprising an SAW device and further electronic components for which the SAW device has to be realized on a semiconductor substrate, generally Si or possibly GaAs. Since silicon is not piezoelectric, an insulating dielectric layer is deposited over the silicon, which is possibly covered by an epitaxial layer, and then the interdigital transducer and a piezoelectric layer thereover are deposited. This latter is generally of zinc oxide (ZnO), but may also be of another material, such as CdS.

A high piezoelectric coupling is required to generate a sufficiently strong surface wave. Abovementioned paper discusses also the manner in which said high piezo-electric coupling may be obtained through the calculation of various configurations. The relative change $\Delta v/v$ in the phase velocity v is considered as a good measure of said piezoelectric coupling. Such a good piezoelectric coupling is found to exist, in particular, in that configuration in which the transducers are deposited on the dielectric layer/piezoelectric layer interface, and not in that configuration in which the transducers are deposited at the other, outwardly facing side of the piezoelectric layer.

Said SAW devices having a multilayer structure on a semiconductor substrate have a much stronger electromagnetic feedthrough than the SAW devices on LiNbO$_3$ and quartz. This is because said feedthrough mainly takes place via the semiconductor substrate. The deposition of a metal layer on the bottomside and the use of a metal packaging with good closure will have little effect in this case. The use of a multistrip coupler is not possible because of the unduly low piezoelectric coupling in said multilayer structures. Symmetrical driving of the transducers and fitting a metal surface between the transducers are also found to reduce the feedthrough inadequately.

The doping levels of epitaxial layer and substrate required to render a monolithic integration of SAW device and electronic components effectively possible are fixed, as is the thickness of the epitaxial layer. Although the conduction can be improved at the location where the SAW device is deposited by an additional diffusion step or implantation step, experiments have shown that the conducting (possibly grounded) layer thus obtained offers inadequate screening. As a result, the electromagnetic feedthrough cannot adequately be suppressed and it remains extremely troublesome in said multilayer structures, inter alia, as a result of the boundary conditions imposed by the remaining electronic components.

The object of the invention is to eliminate this problem. In a SAW device of the type mentioned in the introduction this is achieved in a manner such that a metal layer which serves to reduce electromagnetic feedthrough between the input and output transducer via the semiconductor substrate is deposited between the semiconductor substrate and the dielectric layer at least at the location of the transducers. If required, said metal layer can be grounded. The great advantage of this embodiment is that it is entirely IC-compatible and that monolithic integration of SAW devices and other electronic components is possible. The metal layer may extend over the entire interface between substrate and dielectric layer, but may also extend essentially over the interface at the location of the transducers. In this latter case, the reduction in feedthrough may be somewhat less. But in that case interaction is also possible between the surface acoustic wave and the charge carriers in the semiconductor substrate via the uncovered part of the interface between the transducers.

The invention will be explained in more detail on the basis of some exemplary embodiments with reference to the drawing, in which:

Figure 1 shows a diagrammatic plan view of a uniform interdigital transducer;

Figure 2 shows the simple construction of a SAW delay line on a piezoelectric substrate; and

Figures 3a to 3c show examples of a SAW device having multilayer structure on a semiconductor substrate.

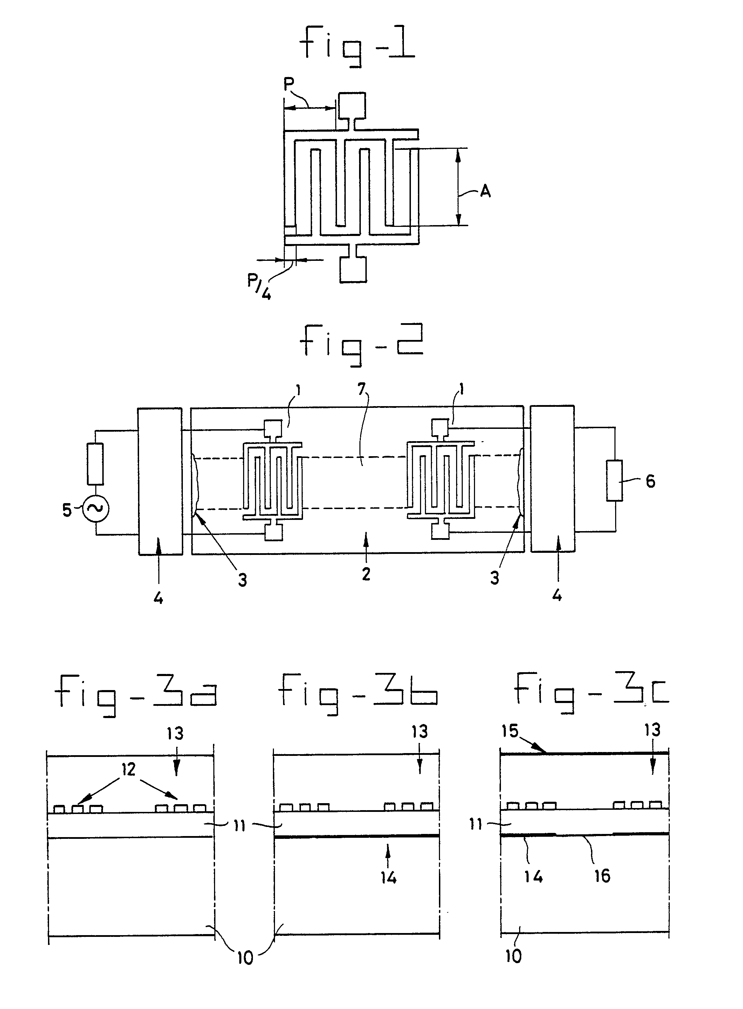

Figure 1 shows, as an example, an interdigital pattern of a uniform interdigital transducer having a period p, aperture A and three pairs of electrodes.

Figure 2 shows, as an example, the construction in simplified form of a SAW delay line having uniform interdigital transducers 1 on a homogeneous piezoelectric substrate 2. 3 indicates an acoustic absorption element, 4 a matching network, 5 a source and 6 a load. 7 indicates the path of the acoustic beam.

Figure 3a shows the known multilayer structure of an SAW device on a semiconductor substrate 10. 11 indicates the dielectric layer, 12 the interdigital transducers and 13 the piezoelectric layer.

Depositing a metal layer 14, which is grounded if necessary during finishing, during manufacture on the semiconductor substrate 10 (as is shown in Figure 3b) interrupts the field lines which are responsible for most of the electromagnetic feedthrough, namely via the semiconductor substrate. An insulating dielectric layer 11 now has to be deposited on said metal layer, which is, for example, of aluminium, since this is an IC-compatible material. For, however, growing an insulating silicon oxide layer by thermal oxidation, which was in fact possible in the case of the device of Figure 3a, is now no longer possible. For said layer 11, IC-compatible materials, such as $SiO_2$ and $Si_3N_4$, which are deposited by means of sputtering, plasma deposition, etc., are preferred.

The interdigital transducers or the pattern 12 are deposited on the dielectric layer 11. And finally, the piezoelectric layer 13 is deposited on top of the latter.

For the usual conductions of epitaxial layer and substrate, which are imposed by the electronics in the case of these monolithically integrated units, it is the case that they may be regarded as infinitely conducting for the conversion mechanism and propagation mechanism of the acoustic wave. This approximation is accurate enough for frequencies used in practice. The application of a metal layer with good conduction on the semiconductor substrate therefore has no effect on the piezoelectric coupling (and consequently on the conversion of electrical signal to acoustic signal and vice versa) and on the propagation. Since the metal layer is chosen to be thin, the mechanical effect will also be small.

Experiments with a SAW filter having this new structure, which had a centre frequency of approximately 100 MHz, have shown that an additional 10-15 dB reduction in feedthrough is already obtained.

In the structure shown in Figures 3b and 3c, most of the electromagnetic feedthrough, namely via the semiconductor substrate, is eliminated. The rest of the feedthrough, mainly through the piezoelectric layer and the air present above it, can be reduced by good packaging. This is, however, relatively expensive and consequently undesirable. By now also depositing a metal layer (if necessary, grounded) on the piezoelectric layer, as indicated by 15 in Figure 3c, a good reduction in electromagnetic feedthrough is also obtained. Said metal layer 15 may at the same time serve as passivation for the usually inadequately stable piezoelectric layer. The metal layer deposited does not have any great effect on the piezoelectric coupling.

As stated previously, the said metal layer 14 does not need to extend over the entire interface between substrate 10 and dielectric layer 11. As is shown in Figure 3c, a surface region 16 of the interface may remain uncovered. As a result, an interaction may occur between the surface acoustic wave propagating between the transducers 12 and the part of the semiconductor substrate situated beneath the region 16.

feedthrough.

## Claims

1. Surface acoustic wave device having a multilayer structure comprising a semiconductor substrate, an insulating dielectric layer thereon, a set of at least one interdigital input and output transducer deposited thereon, and a piezoelectric layer thereover, in which an electrical input signal is converted in the input transducer and the surface acoustic wave resulting therefrom propagates over the surface and is converted into an electrical output signal in the output transducer, characterized in that a metal layer which serves to reduce electromagnetic feedthrough between the input and output transducer via the semiconductor substrate is deposited between the semiconductor substrate and the dielectric layer at least at the location of the transducers.

2. Surface acoustic wave device according to claim 1, characterized in that the metal layer extends over the entire interface between semiconductor substrate and dielectric layer.

3. Surface acoustic wave device according to claim 1 or 2, characterized in that the piezoelectric layer is provided at the outside with a further metal layer which serves to reduce electromagnetic feedthrough via the piezoelectric layer and the air present above it.

4. Surface acoustic wave device according to one of the preceding claims, characterized in that the (further) metal layer is grounded.

5. Surface acoustic wave device according to one of the preceding claims, in which the semiconductor substrate is of Si or GaAs, the insulating dielectric layer is of $SiO_2$ or $Si_3N_4$, the piezoelectric layer is of ZnO or CdS, and the metal layer is of Al, respectively.

6. Surface acoustic wave device according to one of the preceding claims, used in a monolithically integrated unit as a filter having a centre frequency of approx. 100 MHz, which filter has an additional reduction of 10-15 dB in electromagnetic

EP 0 350 993 A1

fig-1

fig-2

fig-3a    fig-3b    fig-3c

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | GB-A-2 152 315 (CLARION CO. LTD) * Page 1, lines 104-121; page 2, lines 81-90; figures 3,6,12 * | 1-3 | H 03 H 9/02 |
| A | | 5 | |
| D,Y | IEEE TRANSACTIONS ON MICROWAVE THEORY AND TECHNIQUES, vol. 23, no. 9, September 1975, pages 765-767; A. VENEMA et al.: "Enhancement of surface-acoustic-wave piezoelectric coupling in three-layer substrates" * Page 765, right-hand column, lines 1-18; figures 1B,3 * | 3 | |
| D,A | IDEM | 5 | |
| A | PATENT ABSTRACTS OF JAPAN, vol. 3, no. 61 (E-113), 26th May 1979, page 84 E 113; & JP-A-54 40 541 (HITACHI SEISAKUSHO K.K.) 30-03-1979 * Abstract * | 1,3,4 | |
| A | US-A-4 437 031 (GUNSHOR et al.) * Column 4, lines 35-41; figure 4 * | 1,2,4,5 | TECHNICAL FIELDS SEARCHED (Int. Cl.5) H 03 H |
| A | PATENT ABSTRACTS OF JAPAN, vol. 1, no. 32, 29th March 1977, page 1502 E 76; & JP-A-51 127 650 (TOKOH K.K.) 06-11-1976 * Abstract * -/- | 1,2 | |

The present search report has been drawn up for all claims

| Place of search | Date of completion of the search | Examiner |
|---|---|---|
| THE HAGUE | 03-10-1989 | DEN OTTER A.M. |

EPO FORM 1503 03.82 (P0401)

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | APPLIED PHYSICS LETTERS, vol. 37, no. 2, 15th July 1980, pages 147-150, American Institute of Physics, New York, US; M.R. MELLOCH et al.: "Interface transduction in the ZnO-SiO2-Si surface acoustic wave device configuration" * Page 147, left-hand column, line 1 - right-hand column, line 18; figure 1 * | 3,5,6 | |
| A | PROCEEDINGS OF THE INSTITUTE OF ELECTRICAL AND ELECTRONIC ENGINEERS, vol. 63, no. 6, June 1975, page 990; S. POOKAIYAUDOM: "Electromagnetic leakage suppression by interdigital transducers" * Page 990, left-hand column, lines 1-13 * | 1,4 | |

TECHNICAL FIELDS SEARCHED (Int. Cl.5)

The present search report has been drawn up for all claims

| Place of search | Date of completion of the search | Examiner |
|---|---|---|
| THE HAGUE | 03-10-1989 | DEN OTTER A.M. |

EPO FORM 1503 03.82 (P0401)